Europäisches Patentamt

European Patent Office

Office européen des brevets

(11) Numéro de publication: **0 030 191**
**B1**

# FASCICULE DE BREVET EUROPEEN

(45) Date de publication du fascicule du brevet:
**25.05.83**

(21) Numéro de dépôt: **80401693.9**

(22) Date de dépôt: **27.11.80**

(51) Int. Cl.³: **H 04 N 3/18, H 03 K 4/83**

(54) Générateur de tension continue d'alimentation, et récepteur de télévision comportant un tel générateur.

(30) Priorité: **04.12.79 FR 7929765**

(43) Date de publication de la demande:
**10.06.81 Bulletin 81/23**

(45) Mention de la délivrance du brevet:
**25.05.83 Bulletin 83/21**

(84) Etats contractants désignés:
**BE DE GB IT NL SE**

(56) Documents cités:
**EP-A-0 007 866**
**EP-A-0 008 263**
**FR-A-2 318 545**

(73) Titulaire: **THOMSON-BRANDT, 173, Boulevard
Haussmann, F-75379 Paris Cedex 08 (FR)**

(72) Inventeur: **Colineau, Joseph, "THOMSON-CSF"
SCPI 173, bld Haussmann, F-75360 Paris Cedex 08 (FR)**
Inventeur: **Rilly, Gérard, "THOMSON-CSF"
SCPI 173, bld Haussmann, F-75360 Paris Cedex 08 (FR)**

(74) Mandataire: **Grynwald, Albert et al, THOMSON-CSF
SCPI 173, Bld Haussmann, F-75379 Paris Cedex 08 (FR)**

## Générateur de tension continue d'alimentation et récepteur de television comportant un tel générateur

L'invention est relative à un générateur d'une tension continue d'alimentation dans un récepteur de télévision à circuit de balayage vertical en mode commuté du type de celui décrit dans la demande de brevet numéro EP-A-8 263 du 20/7/79 au nom de la demanderesse.

Le circuit de balayage vertical décrit dans cette demande de brevet comporte une bobine assurant la déviation verticale du pinceau d'électrons du tube cathodique du récepteur qui est alimenté en courant électrique par un générateur tirant son énergie exclusivement des impulsions de retour-ligne, c'est-à-dire de la surtension obtenue aux bornes du déviateur horizontal lorsque le courant s'annule dans ce dernier. Ces impulsions de retour-ligne sont récupérées aux bornes de l'enroulement secondaire d'un transformateur appelé »transformateur-ligne« alimentant un circuit redresseur en série avec l'ensemble en parallèle et en sens inverse — de façon à conduire le courant dans les deux sens — d'un interrupteur actif et d'une diode, l'interrupteur actif étant commandé pour que le courant délivré varie de la manière désirée, c'est-à-dire sensiblement en dents de scie. A cet effet l'interrupteur est, à chaque ligne, conducteur pendant une durée qui est fonction du numéro de cette ligne.

Par ailleurs la tension continue d'alimentation des amplificateurs vidéo attaquant les trois canons à électrons d'un tube cathodique d'un récepteur de télévision en couleurs ont été jusqu'à présent alimentés en tension continue, de l'ordre de 200 volts, également par redressement d'impulsions de retour-ligne fournies par un second enroulement secondaire du transformateur très haute tension ou transformateur-ligne. Un exemple d'un tel récepteur est décrit dans le brevet français 2 318 545.

Ledit transformateur-ligne comporte donc au moins deux enroulements secondaires, l'un pour le circuit de balayage vertical et l'autre pour l'alimentation continue des amplificateurs vidéo.

Selon l'invention le même enroulement secondaire du transformateur-ligne alimente à la fois le circuit de balayage vertical et un circuit redresseur aux bornes duquel est obtenue une tension continue, notamment pour l'alimentation des amplificateurs vidéo. Le circuit redresseur comporte une diode qui est branchée dans le même sens que la diode en parallèle sur l'interrupteur actif.

On a en effet constaté que la tension continue ainsi prélevée n'affectait pas le courant fourni au déviateur vertical qui doit varier de façon bien déterminée pour qu'une image non déformée soit restituée par le récepteur de télévision.

Il n'est ainsi pas nécessaire de prévoir un second enroulement secondaire du transformateur-ligne, ce qui diminue l'encombrement du téléviseur ainsi constitué et réduit de coût. Cet avantage est appréciable dans le cas des téléviseurs transistorisés en couleur fabriqués en série.

D'autres dispositions et avantages de l'invention apparaîtront avec la description de l'un de ses modes de réalisation, celle-ci étant effectuée en se référant aux dessins ci-annexés sur lesquels:

— la figure 1 est un schéma d'un circuit selon l'invention,
— les figures 2 à 8 sont des diagrammes montrant le fonctionnement du circuit de la figure 1.

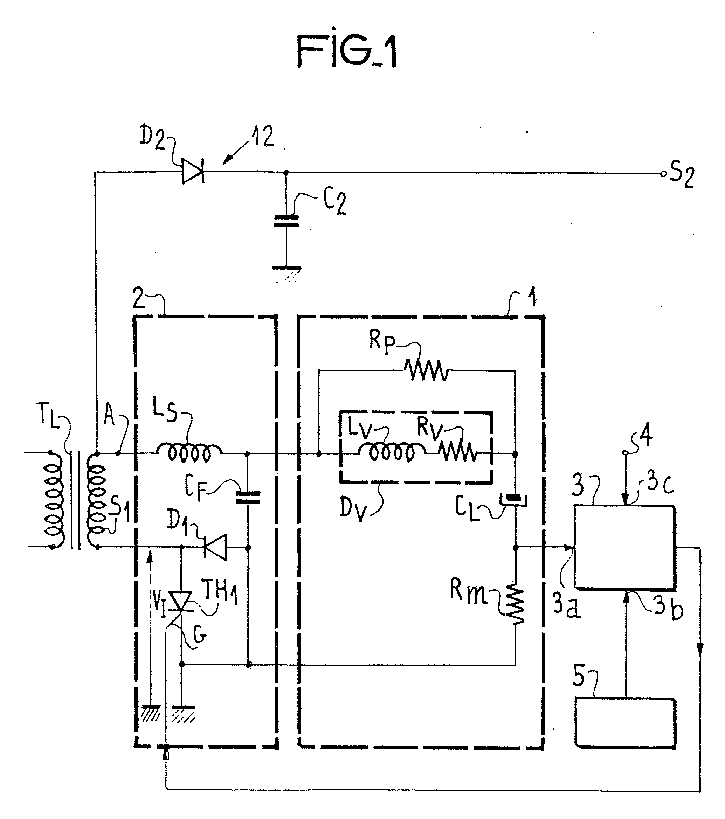

Le circuit de balayage représenté sur la figure 1 comporte un déviateur vertical $D_v$ équivalent à une inductance $L_v$ et une résistance $R_v$ en série, qui est en parallèle avec une résistance $R_p$ et qui est en série avec un condensateur de liaison $C_L$ et une résistance de mesure $R_m$.

L'ensemble formé par ce déviateur $D_v$, le condensateur $C_L$ et la résistance $R_m$ ainsi que la résistance $R_p$ forme une impédance de charge 1 d'un générateur 2.

Le condensateur $C_L$ est du type électrochimique polarisable et est choisi de manière qu'à ses bornes la tension ait une valeur moyenne positive suffisamment élevée pour qu'aux bornes de la charge on obtienne une tension toujours positive quel que soit le sens duc ourant traversant le déviateur $D_v$.

Le générateur 2 doit donc être bidirectionnel en courant mais monodirectionnel en tension.

Ce générateur 2 comporte un interrupteur actif bidirectionnel en courant et monodirectionnel en tension constitué, dans l'exemple, d'un thyristor $TH_1$ (interrupteur actif) et d'une diode $D_1$ montés en sens inverse. Cet interrupteur est en série avec l'enroulement secondaire $S_1$ d'un transformateur ligne $T_L$ ainsi qu'avec une inductance $L_S$ non couplée au transformateur et un condensateur $C_F$.

La cathode du thyristor $TH_1$ et l'anode de la diode $D_1$ sont connectées à la masse.

Le condensateur $C_F$ est disposé entre, d'une part, la masse et, d'autre part, la borne de l'inductance $L_s$ qui est opposée à celle reliée à l'enroulement $S_1$.

L'inductace $L_s$ et le condensateur $C_F$ assurant un filtrage de la tension fournie par l'enroulement $S_1$ à la fréquence de 16 KHz.

La capacité du condensateur $C_F$ est suffisamment élevée pour que la tension à ses bornes soit pratiquement continue.

La gâchette G du thyristor $TH_1$ est connectée à un circuit de commande de 3 délivrant des impulsions telles qu'à chaque ligne le thyristor soit conducteur pendant un temps qui est fonction du numéro de cette ligne.

En variante à la place d'un thyristor on utilise en transistor du type NPN ou PNP ou un autre interrupteur.

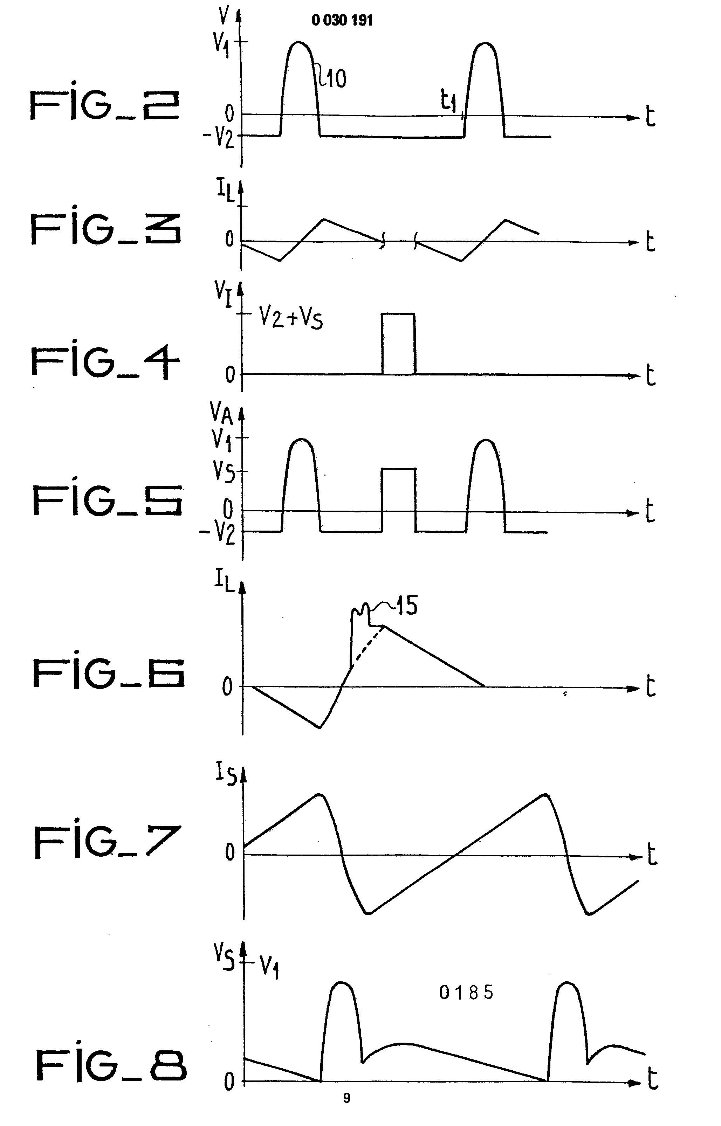

Pendant la durée de balayage vertical l'enroulement $S_1$ du transformateur $T_L$ délivre des impulsions de retour-ligne 10 (figure 2) à valeurs de crête $V_1$ et $-V_2$.

La valeur moyenne du courant traversant le déviateur $D_v$ est pratiquement égale à la valeur moyenne du courant traversant l'inductance $L_s$.

Les variations en fonction du temps t de l'intensité $I_L$ du courant dans l'inductance $L_s$ sont représentées sur la figure 3.

Le diagramme de la figure 4 représente les variations en fonction du tems t de la tension $V_1$ aux bornes de l'interrupteur actif à thyristor $TH_1$ et diode $D_1$. La figure 5 montre les variations du potentiel au point A à la jonction entre l'enroulement $S_1$ et l'inductance $L_s$.

Comme le montre la figure 3 la variation du courant dans l'inductance $L_s$ dépend de l'instant de fermeture du thyristor $TH_1$.

Ainsi l'intensité moyenne du courant dans cette inductance, et donc l'intensité du courant dans le déviateur vertical $D_v$, dépend de cet instant de fermeture.

Plus le thyristor $TH_1$ est déclenché à un instant en avance sur l'instant $t_1$ de début de retour ligne plus le courant moyen dans l'inductance $L_s$ décroît par rapport à sa valeur maximale correspondant au cas où le thyristor est toujours bloqué.

Le circuit de commande 3 est du type à contre-réaction. Il comporte une entrée $3_a$ recevant la tension aux bornes de la résistance $R_m$, et une entrée $3_b$ connectée à la sortie d'un générateur 5 fournissant une tension en dents de scie affectées de corrections, telle que la correction en S et qui est l'image du courant nécessaire à une bonne déviation verticale. Une entrée 3 reçoit des impulsions à la fréquence ligne pour la synchronisation à cette fréquence du circuit de commande 3 cette fréquence.

Lorsque la tension aux bornes de la résistance $R_m$ augmente l'instant de déclenchement du thyristor $TH_1$ est avancé dans le temps, le courant dans le déviateur diminue et, de même, la tension aux bornes de la résistance de mesure $R_m$ diminue. On obtient bien une régulation telle que le courant traversant le déviateur vertical $D_v$ est une image de la tension fournie par le générateur 5.

La figure 5 montre que la tension obtenue entre le point A et la masse varie comme la tension fournie par l'enroulement $S_1$ entre les valeurs $V_1$ et $-V_2$.

Selon l'invention au point A est connectée l'anode d'une diode $D_2$ dont la cathode est reliée à la masse par l'intermédiaire d'un condensateur $C_2$.

Les impulsions de retour ligne sont redressées par le circuit 12 à diode $D_2$ et condensateur $C_2$ et on dispose en sortie $S_2$, aux bornes du condensateur $C_2$, d'une tension continue utilisable, notamment pour l'alimentation de l'étage vidéo du récepteur de télévision.

Le fonctionnement du circuit de balayage vertical n'est pas affecté par le branchement en parallèle de ce circuit redresseur. En effet, la diode $D_2$ étant branchée dans le même sens que la diode $D_1$ elle est, bien entendu, conductrice en même temps que cette dernière. En d'autres termes la diode $D_2$ est conductrice lorsque l'interrupteur actif est fermé, c'est-a-dire lorsque l'enroulement $S_1$ fournit de l'énergie. Ainsi l'énergie consommée par le circuit 12 $D_2$, $C_2$ et par la charge branchée aux bornes du condensateur $C_2$ est tirée de l'enroulement $S_1$ et non du circuit de balayage vertical.

Un débit de l'alimentation 12 n'est cependant pas sans influence sur l'intensité des courants traversant la diode $D_1$ et le thyristor $TH_1$. En effet comme le montre la figure 6, qui est un diagramme de variation en fonction du temps t de l'intensité $I_L$ du courant traversant l'inductance $L_s$ lorsqu'une charge est reliée à la borne $S_2$, l'intensité $I_L$ présente un pic 15 pour les valeurs positives du courant correspondant à la conduction de la diode $D_1$.

La tension d'alimentation obtenue au point $S_2$ est ajustée à la valeur désirée par le choix du nombre de spires de l'enroulement $S_1$ du transformateur $T_L$. Si ce nombre ne permet pas d'obtenir l'intensité désirée dans le déviateur $D_v$ il est possible alors d'obtenir cette intensité convenable par exemple en modifiant l'inductance $L_s$ et/ou l'impédance du déviateur $D_v$.

Inversement le déviateur vertical ne perturbe pas le fonctionnement de l'alimentation continue. Une condition est cependant à respecter pour obtenir ce résultat: la tension $V_s$ aux bornes du condensateur $C_F$ (figure 8) doit rester inférieure à la tension crête $V_1$ aux bornes de l'enroulement $S_1$.

Le courant $I_s$ traversant le déviateur vertical $D_v$ variant en dents de scie (figure 7) la tension de sortie $V_s$ aux bornes du condensateur $C_F$ (figure 8) présente une valeur importante lors du retour de balayage vertical. Si pendant l'aller de balayage vertical la tension $V_s$ reste nettement inférieure à la tension de crête $V_1$ par contre lors du retour de balayage vertical cette tension prend des valeurs importantes. Il faut donc réaliser le circuit de balayage vertical pour que, pendant le retour trame ou retour de balayage vertical, cette tension $V_s$ ne dépasse pas la tension de crête $V_1$. On a constaté qu'en pratique cette condition supplémentaire n'impose aucune contrainte dans la réalisation du balayage vertical car dans tous les montages réalisés cette condition est satisfaite.

La diode $D_2$ et le condensateur de filtrage $C_2$ peuvent jouer un rôle de protection à l'égard des impulsions parasites pouvant provenir par exemple de la commutation de l'interrupteur actif.

Le circuit représenté sur la figure I est utilisé principalement dans les récepteurs de télévision couleur transistorisés.

## Revendications

1. Générateur d'une tension continue d'alimentation, notamment des amplificateurs de l'étage vidéo, dans un récepteur de télévision comportant un circuit de balayage vertical dans lequel l'énergie produise le courant traversant le déviateur vertical ($D_v$) est tirée exclusivement d'un circuit (2) alimenté par des impulsions de retour-ligne fournies par l'enroulement secondaire ($S_1$) d'un transformateur ($T_L$), un condensateur ($C_L$) en série avec le déviateur vertical étant tel que la tension aux bornes de l'ensemble comprenant ce déviateur et ce condensateur ait un signe constant indépendant du sens du courant traversant ce déviateur, le circuit (2) comportant un interrupteur actif ($TH_1$) commandé et modulé à la fréquence ligne ainsi qu'une diode ($D_1$) en parallèle sur cet interrupteur actif et branchée en sens inverse de ce dernier, caractérisé en ce qu'un circuit redresseur (2) à diode ($D_2$) branchée dans le même sens que la diode ($D_1$) en parallèle sur l'interrupteur ($TH_1$) est relié à l'enroulement secondaire ($S_1$) du circuit (2) pour fournir ladite tension continue d'alimentation.

2. Générateur selon la revendication 1, caractérisé en ce que la diode ($D_2$) du circuit redresseur est en série avec un condensateur ($C_2$).

3. Générateur selon la revendication 1 ou 2, caractérisé en ce que l'interrupteur actif ($TH_1$, $D_1$) du circuit de balayage vertical comporte un thyristor ($TH_1$) ou un transistor.

4. Générateur selon la revendication 2, caractérisé en ce que le signal fourni par l'enroulement secondaire ($S_1$) est injecté sur l'anode de la diode ($D_2$) et en ce que la tension continue de sortie est prélevée aux bornes du condensateur ($C_2$).

5. Générateur selon l'une quelconque des revendications précédentes, caractérisé en ce que le circuit redresseur ($D_2$, $C_2$) est en série avec l'ensemble formé par l'interrupteur actif ($TH_1$) et la diode ($D_1$) en parallèle.

6. Générateur selon la revendication 5, caractérisé en ce que ledit ensemble ($TH_1$, $D_1$) est disposé entre une borne de l'enroulement secondaire ($S_1$) et la masse et le circuit redresseur ($D_2$, $C_2$) est entre l'autre borne de l'enroulement secondaire et la masse.

7. Récepteur de télévision, notamment en couleur et du type transistorisé, caractérisé en ce qu'il comporte un circuit de balayage vertical et un générateur selon l'une quelconque des revendications précédentes.

## Patentansprüche

1. Speisegleichspannungsgenerator, besonders zur Speisung von Verstärkern der Video-Stufe in einem Fernsehempfänger, der eine Vertikal-Ablenkschaltung aufweist, in welcher die Energie, welche den durch die Vertikalablenk-vorrichtung ($D_v$) gehenden Strom liefert, ausschließlich von einer Schaltung (2) abgenommen wird, die gespeist wird von Zeilenrücklaufimpulsen, die von der Sekundärwicklung ($S_1$) eines Transformators ($T_L$) geliefert werden, wobei ein Kondensator ($C_L$) in Reihe mit der Vertikal-Ablenkvorrichtung liegt, so daß die Spannung an den Klemmen der Anordnung, welche diese Ablenkvorrichtung und diesen Kondensator umfaßt, ein konstantes Vorzeichen hat, unabhängig von der Richtung des durch diese Ablenkvorrichtung gehenden Stroms, wobei die Schaltung (2) einen aktiven Schalter ($TH_1$) aufweist, der von der Zeilenfrequenz moduliert und gesteuert ist, sowie eine parallel zu diesem aktiven Schalter liegende Diode ($D_1$), die in umgekehrter Richtung wie die Richtung dieses Schalters angeschlossen ist, dadurch gekennzeichnet, daß eine Gleichrichterschaltung (12) mit Diode ($D_2$), die im gleichen Sinn wie die Diode ($D_1$) parallel zum Schalter ($TH_1$) angeschlossen ist, mit der Sekundärwicklung ($S_1$) der Schaltung (2) verbunden ist, um die Speisegleichspannung zu liefern.

2. Generator nach Anspruch 1, dadurch gekennzeichnet, daß die Diode ($D_2$) der Gleichrichterschaltung in Serie mit einem Kondensator ($C_2$) liegt.

3. Generator nach Anspruch 1 oder 2, dadurch gekennzeichnet, daß der aktive Schalter ($TH_1$, $D_1$) der Vertikal-Ablenkschaltung einen Thyristor ($TH_1$) oder einen Transistor aufweist.

4. Generator nach Anspruch 2, dadurch gekennzeichnet, daß das von der Sekundärwicklung ($S_1$) geleiferte Signal auf die Anode der Diode ($D_2$) gegeben wird und daß die Ausgangsgleichspannung an den Klemmen des Kondensators ($C_2$) abgenommen wird.

5. Generator nach einem der vorangehenden Ansprüche, dadurch gekennzeichnet, daß die Gleichrichterschaltung ($D_2$, $C_2$) in Reihe mit der vom aktiven Schalter ($TH_1$) und der dazu parallelen Diode ($D_1$) gebildeten Anordnung liegt.

6. Generator nach Anspruch 5, dadurch gekennzeichnet, daß die Anordnung ($TH_1$, $D_1$) zwischen einer Klemme der Sekundärwicklung ($S_1$) und der Masse abgeordnet ist und die Gleichrichterschaltung ($D_2$, $C_2$) zwischen der anderen Klemme der Sekundärwicklung und der Masse liegt.

7. Fernsehempfänger, besonders transistorisierter Farbfernsehempfänger, dadurch gekennzeichnet, daß er eine Vertikal-Ablenkschaltung und einen Generator nach einem der vorangehenden Ansprüche aufweist.

## Claims

1. A DC supply voltage generator, especially for feeding amplifiers of the video stage in a television receiver, comprising a vertical deflection circuit in which the energy, which produces the current passing through the vertical deflection means ($D_v$), is exclusively taken out of a circuit (2) which is supplied by horizontal fly-back pulses supplied from the secondary winding (S₁) of a transformer (T_L), wherein a capacitor (C_L) is connected in series to the vertical deflection means so that the voltage across the terminals of the arragement comprising said deflection means and said capacitor has a constant sign irrespective of the direction of the current passing through said deflection means, wherein the circuit (2) includes an active switch (TH₁) modulated and controlled by the line frequency and further includes a diode (D₁) in parallel to said active switch and connected in opposite sense to the sense of said switch, characterized in that a rectifier circuit (12) including a diode (D₂), which is connected in parallel to the switch (TH₁) in the same sense as the diode (D₁), is connected to the secondary winding (S₁) of the circuit (2) so as to supply the DC supply voltage.

2. A generator as claimed in claim 1, characterized in that the diode (D₂) of the rectifier circuit is connected in series to a capacitor (C₂).

3. A generator as claimed in claim 1 or claim 2, characterized in that the active switch (TH₁, D₁) of the vertical deflection circuit comprises a thyristor (TH₁) or a transistor.

4. A generator as claimed in claim 2, characterized in that the signal supplied by the secondary winding (S₁) is applied to the anode of the diode (D₂), and that the DC output voltage is taken out at the terminals of the capacitor (C₂).

5. A generator as claimed in any of the preceding claims, characterized in that the rectifier circuit (D₂, C₂) is connected in series to the circuit formed by the active switch (TH₁) and the diode (D₁) connected in parallel thereto.

6. A generator as claimed in claim 5, characterized in that the arrangement (TH₁, D₁) is disposed between one terminal of the secondary winding (S₁) and ground, and that the rectifier circuit (D₂, C₂) is disposed between the other terminal of the secondary winding and ground.

7. A television receiver, especially a transistorized colour television receiver, characterized by comprising a vertical deflection circuit and a generator as claimed in any of the preceding claims.

# FIG.1

FIG_2

0 030 191

FIG_3

FIG_4

FIG_5

FIG_6

FIG_7

FIG_8

0 1 8 5